# EUROPEAN PATENT APPLICATION

(11) **EP 3 561 368 A1**
(43) Date of publication of application: **30.10.2019**
(21) Application number: 18882511.1
(22) Date of filing: 28.11.2018
(51) Int. Cl.: F21S 2/00, F21K 9/64, F21V 9/40, G02B 5/23, B32B 27/20, B32B 27/30, C09K 11/06, F21Y 115/10

(54) **LIGHTING MODULE COMPRISING COLOR CONVERSION FILM**

(30) Priority: 28.11.2017 KR 20170160676
(71) Applicant: LG Chem, Ltd., Seoul 07336 (KR)
(72) Inventor: MIN, Sung Yong, Daejeon 34122 (KR); SHIN, Dong Mok, Daejeon 34122 (KR); KIM, Nari, Daejeon 34122 (KR); KIM, Ji Ho, Daejeon 34122 (KR); OH, Hye Mi, Daejeon 34122 (KR)
(74) Representative: Goddar, Heinz J.
(86) International application number: PCT/KR2018/014867
(87) International publication number: WO 2019/107937

(57) **Abstract**

The present specification relates to a lighting module including a flexible substrate; a micro LED light source array provided on the flexible substrate; and a color conversion film stacked on the micro LED light source array, in which the color conversion film includes: a resin matrix; and an organic fluorescent substance dispersed in the resin matrix, when the color conversion film is irradiated with light including a wavelength of 450 nm, the color conversion film has a light emission peak's full width at half maximum of 50 nm or less and has a maximum light emission wavelength within a range of 600 nm to 660 nm, and the resin matrix includes a thermoplastic resin having a glass transition temperature of 110°C to 145°C.

## Description

### [Technical Field]

The present application claims priority to and the benefit of Korean Patent Application No. 10-2017-0160676 filed in the Korean Intellectual Property Office on November 28, 2017, the entire contents of which are incorporated herein by reference.

The present specification relates to a lighting module including a color conversion film.

### [Background Art]

High efficiency LEDs have been usually used as existing vehicle lamps, but the design of LED lamps is limited due to the use of hard substrates with a chip size of several mm or more, and accordingly, the design of lamp modules has also been limited. Further, since the LEDs based on existing inorganic fluorescent substances have very wide light emission spectra, the color purity is lowered, so that there is an disadvantage in that it is difficult to express vivid colors and adjust colors. The OLEDs based on organic fluorescent substances have advantages in terms of color purity and flexibility, but have limitations in utilization as a vehicle lamp in terms of durability and mass production.

### [Detailed Description of Invention]

### [Technical Problem]

The present specification provides a lighting module including a color conversion film.

### [Technical Solution]

An exemplary embodiment of the present specification provides a lighting module including: a flexible substrate; a micro LED light source array provided on the flexible substrate; and a color conversion film stacked on the micro LED light source array, in which the color conversion film includes: a resin matrix; and an organic fluorescent substance dispersed in the resin matrix, when the color conversion film is irradiated with light including a wavelength of 450 nm, the color conversion film has a light emission peak's full width at half maximum of 50 nm or less and has a maximum light emission wavelength within a range of 600 nm to 660 nm, the resin matrix includes a thermoplastic resin having a glass transition temperature of 110°C to 145°C, and the thermoplastic resin includes one or more of alpha methyl styrene-styrene-acrylonitrile, a cyclic olefin copolymer, phenyl methyl styrene-styrene-acrylonitrile (PMI-SAN), styrene maleic anhydride, cellulose acetate propionate (CAP), poly(4-tert-butylstyrene)(PTBS), poly(methylphenyl)silane (PMPS), poly(4-vinylpyridine), poly(methyl methacrylate)(PMMA), and poly(vinyl methacrylate)(PVMA).

According to another exemplary embodiment of the present specification provides a lighting module in which the color conversion film maintains 90% or more of an initial brightness under a condition of 110°C for 1,000 hours or more.

According to another exemplary embodiment of the present specification provides a lighting module in which the color conversion film further includes light diffusion particles.

According to another exemplary embodiment of the present specification provides a lighting module in which when the lighting module is irradiated with light including a wavelength of 450 nm, the lighting module has a light emission peak's full width at half maximum of 40 nm or less and has a maximum light emission wavelength within a range of 620 nm to 660 nm. According to another exemplary embodiment of the present specification provides a lighting module in which when the color conversion film is irradiated with light comprising a wavelength of 450 nm, the color conversion film has a light emission peak's full width at half maximum of 40 nm or less, a maximum light emission wavelength within a range of 620 nm to 660 nm, and a color purity of 99% or more.

According to another exemplary embodiment of the present specification provides a lighting module in which the light including a wavelength of 450 nm is blue light having a maximum light emission wavelength of 450 nm, a full width at half maximum of 40 nm or less, and a monomodal light emission intensity distribution.

According to exemplary embodiment of the present specification provides a lighting module in which the organic fluorescent substance includes any one of a first fluorescent substance in which when the first fluorescent substance is irradiated with light including a wavelength of 450 nm, the first fluorescent substance has a maximum light emission wavelength within a range of 510 nm to 560 nm, a second fluorescent substance in which when the second fluorescent substance is irradiated with light including a wavelength of 450 nm, the second fluorescent substance has a maximum light emission wavelength within a range of 600 nm to 660 nm, and a combination thereof.

According to another exemplary embodiment of the present specification provides a lighting module in which the organic fluorescent substance is a pyrromethene boron complex-based organic fluorescent substance.

According to another exemplary embodiment of the present specification provides a lighting module in which the light source is a blue light emission diode emitting blue light.

According to another exemplary embodiment of the present specification provides a lighting module in which the flexible substrate is a thin-film glass, a metal thin film, a plastic substrate, or a plastic film.

According to another exemplary embodiment of the present specification provides a lighting module further including a color filter having a cut-on wavelength within a range of 530 nm to 630 nm.

### [Advantageous Effects]

The lighting module according to an exemplary embodiment of the present specification may implement stability at high temperature and excellent color purity by using a thermoplastic resin having a glass transition temperature of 110°C to 145°C as a material for a resin matrix.

### [Brief Description of Drawings]

FIG. 1 illustrates a light emission spectrum of a color conversion film produced in Example 1.
FIG. 2 illustrates a light emission spectrum of a color conversion film produced in Example 2.
FIG. 3 illustrates a light emission spectrum of a color conversion film produced in Comparative Example 1.
FIG. 4 illustrates brightness maintenance ratios of the color conversion films according to Examples 1 and 2 and Comparative Examples 2 to 4.

### [Best Mode]

Hereinafter, the present specification will be described in more detail.

In the present specification, "on" means not only being disposed while being physically brought into contact with one layer, but also being disposed on the layer in position. That is, a layer disposed on any one layer may also have another layer therebetween.

When one part "includes" one constituent element in the present specification, unless otherwise specifically described, this does not mean that another constituent element is excluded, but means that another constituent element may be further included.

The glass transition temperature specified in the present specification means a glass transition temperature measured by using differential scanning calorimetry (DSC). Specifically, a glass transition temperature measurement method using the differential scanning calorimetry (DSC) means complying with ISO 11357-1, 11357-2, and 11357-3.

The lighting module according to an exemplary embodiment of the present specification includes: a flexible substrate; a micro LED light source array provided on the flexible substrate; and a color conversion film stacked on the micro LED light source array, in which the color conversion film includes: a resin matrix; and an organic fluorescent substance dispersed in the resin matrix, when the color conversion film is irradiated with light including a wavelength of 450 nm, the color conversion film has a light emission peak's full width at half maximum of 50 nm or less and has a maximum light emission wavelength within a range of 600 nm to 660 nm, the resin matrix includes a thermoplastic resin having a glass transition temperature of 110°C to 145°C, and the thermoplastic resin includes one or more of alpha methyl styrene-styrene-acrylonitrile, a cyclic olefin copolymer, phenyl methyl styrene-styrene-acrylonitrile (PMI-SAN), styrene maleic anhydride, cellulose acetate propionate (CAP), poly(4-tert-butylstyrene)(PTBS), poly(methylphenyl)silane (PMPS), poly(4-vinylpyridine), poly(methyl methacrylate)(PMMA), and poly(vinyl methacrylate)(PVMA).

Since the surface temperature of a micro LED used as a light source is 100°C or more, a color conversion layer requires stability at high temperature in a process in which a color conversion film is irradiated with light emitted from the light source.

Since the lighting module according to an exemplary embodiment of the present specification has excellent heat resistance by including a thermoplastic resin having a glass transition temperature of 110°C to 145°C in the resin matrix, a change in brightness of the color conversion film may be very small even under the conditions of storage at high temperature for a long period of time.

In particular, when polycarbonate which does not satisfy a glass transition temperature range of 110°C to 145°C is used as a thermoplastic resin, a decrease in brightness of the color conversion film may be affected as radicals are produced under high temperature conditions.

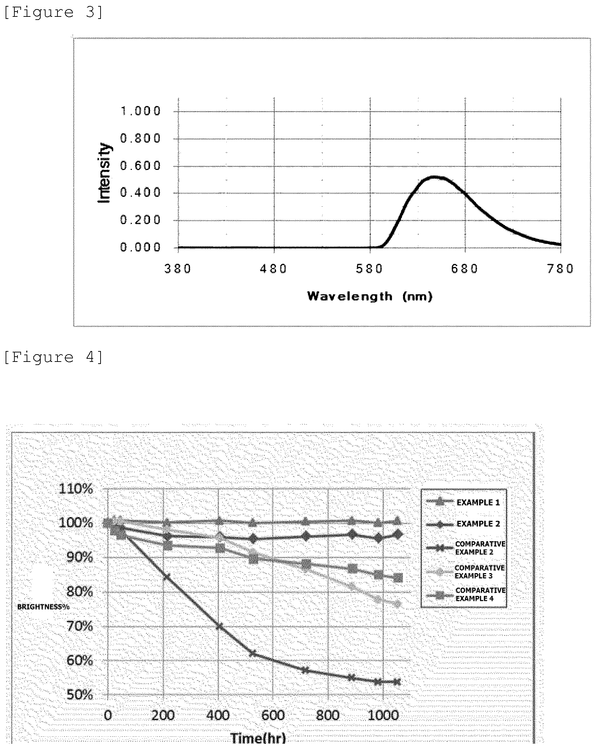

FIG. 4 illustrates experimental results capable of exhibiting excellent heat resistance in the case of a color conversion film produced by including a thermoplastic resin having a glass transition temperature of 110°C to 145°C in a resin matrix (Examples 1 and 2) as compared to the other cases (Comparative Examples 2 to 4).

When alpha methyl styrene-styrene-acrylonitrile is used as the thermoplastic resin, the alpha methyl styrene-styrene-acrylonitrile may include alpha methyl styrene, styrene, and acrylonitrile in an amount of 65.7 wt%, 6.3 wt%, and 28 wt%, respectively, based on 100 wt% of the thermoplastic resin.

The resin matrix may also be composed only of the thermoplastic resin, and an additive may also be added within a range that does not impair the object of the present invention, if necessary.

It is preferred that the resin matrix has a weight average molecular weight of 10,000 g/mol to 140,000 g/mol.

In the color conversion film according to another exemplary embodiment of the present specification, when the color conversion film is irradiated with light including a wavelength of 450 nm, the color conversion film has a light emission peak's full width at half maximum of 40 nm or less and has a maximum light emission wavelength within a range of 620 nm to 660 nm.

As the light including a wavelength of 450 nm, blue light having a maximum light emission wavelength of 450 nm, a full width at half maximum of 40 nm or less, and a monomodal light emission intensity distribution thereof, is used.

An organic fluorescent substance is used in the color conversion film according to an exemplary embodiment of the present specification, so that environmental safety may be improved because heavy metals applied to a quantum dot, such as cadmium, indium, and zinc or used in an inorganic-based fluorescent substance, such as Eu and Sr are not used. Further, since the quantum dot is vulnerable to oxidation by air or moisture, there is a problem in that the process is complicated and difficult, and the inorganic-based organic fluorescent substance has a relatively low light emission efficiency and tricky conditions of grinding and dispersing particles, whereas stability to the air or moisture is excellent and a process of producing a film may be simplified because the above-described organic fluorescent substance is used in the exemplary embodiment.

The organic fluorescent substance according to an exemplary embodiment of the present specification includes any one of a first fluorescent substance in which when the first fluorescent substance is irradiated with light including a wavelength of 450 nm, the first fluorescent substance has a maximum light emission wavelength within a range of 510 nm to 560 nm, a second fluorescent substance in which when the second fluorescent substance is irradiated with light including a wavelength of 450 nm, the second fluorescent substance has a maximum light emission wavelength within a range of 600 nm to 660 nm, and a combination thereof.

According to an exemplary embodiment of the present specification, a pyrromethene boron complex-based organic fluorescent substance may be used as the first fluorescent substance.

According to an example, an organic fluorescent substance of the following Formula 1 may be used. 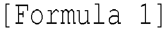 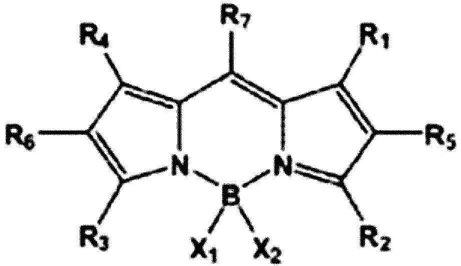 In Formula 1,
X₁ and X₂ are a fluorine group, an alkoxy group, or a cyano group,
R₁ to R₄ are the same as or different from each other, and are each independently hydrogen, a halogen group, an alkyl group, an alkoxy group, a cycloalkyl group, a carboxyl group-substituted alkyl group, an aryl group unsubstituted or substituted with an alkoxy group; -COOR, or a -COOR-substituted alkyl group, and here, R is an alkyl group,
R₅ and R₆ are the same as or different from each other, and are each independently hydrogen, a cyano group, a nitro group, an alkyl group, a carboxyl group-substituted alkyl group, -SO₃Na, or an aryl group unsubstituted or substituted with an arylalkynyl group, R₁ and R₅ may be linked to each other to form a substituted or unsubstituted hydrocarbon ring or a substituted or unsubstituted hetero ring, and R₄ and R₆ may be linked to each other to form a substituted or unsubstituted hydrocarbon ring or a substituted or unsubstituted hetero ring, and
R₇ is hydrogen; an alkyl group; a haloalkyl group; or an aryl group unsubstituted or substituted with a halogen group, an alkyl group, an alkoxy group, an aryl group or an alkylaryl group.

According to an exemplary embodiment, R₁ to R₄ of Formula 1 are the same as or different from each other, and are each independently hydrogen, a fluorine group, a chlorine group, an alkyl group having 1 to 6 carbon atoms, an alkoxy group having 1 to 6 carbon atoms, a cycloalkyl group having 3 to 30 carbon atoms, a carboxyl group-substituted alkyl group having 1 to 6 carbon atoms, an aryl group having 6 to 20 carbon atoms unsubstituted or substituted with an alkoxy group having 1 to 6 carbon atoms, -COOR, or a -COOR-substituted alkyl group having 1 to 6 carbon atoms, and herein, R is an alkyl group having 1 to 6 carbon atoms.

According to another exemplary embodiment, R₁ to R₄ of Formula 1 are the same as or different from each other, and are each independently hydrogen, a chlorine group, a methyl group, a cyclohexyl group, a cycloheptyl group, a cyclooctyl group, a carboxyl group-substituted ethyl group, a methoxy group, a phenyl group, a methoxy group-substituted phenyl group, or a -COOR-substituted methyl group, and here, R is an alkyl group having 1 to 6 carbon atoms.

According to an exemplary embodiment, R₅ and R₆ of Formula 1 are the same as or different from each other, and are each independently hydrogen, a cyano group, a nitro group, an alkyl group having 1 to 6 carbon atoms, a carboxyl group-substituted alkyl group having 1 to 6 carbon atoms, or -SO₃Na.

According to an exemplary embodiment, R₅ and R₆ of Formula 1 are the same as or different from each other, and are each independently hydrogen, a cyano group, a nitro group, an ethyl group, a carboxyl group-substituted ethyl group, or -SO₃Na.

According to an exemplary embodiment, R₇ of Formula 1 is hydrogen; an alkyl group having 1 to 6 carbon atoms; or an aryl group having 6 to 20 carbon atoms unsubstituted or substituted with an alkyl group having 1 to 6 carbon atoms, an alkoxy group having 1 to 6 carbon atoms, an aryl group having 6 to 20 carbon atoms or an alkylaryl group having 7 to 20 carbon atoms.

According to an exemplary embodiment, R₇ of Formula 1 is hydrogen, methyl, ethyl, propyl, butyl, pentyl, phenyl, methylphenyl, dimethylphenyl, trimethylphenyl, naphthyl, biphenyl-substituted naphthyl, dimethylfluorene-substituted naphthyl, terphenyl-substituted dimethylphenyl, methoxyphenyl, or dimethoxyphenyl.

According to an exemplary embodiment, Formula 1 may be represented by the following structural formulae.

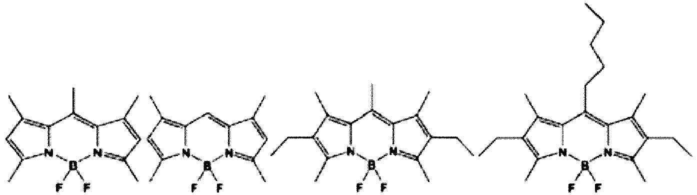

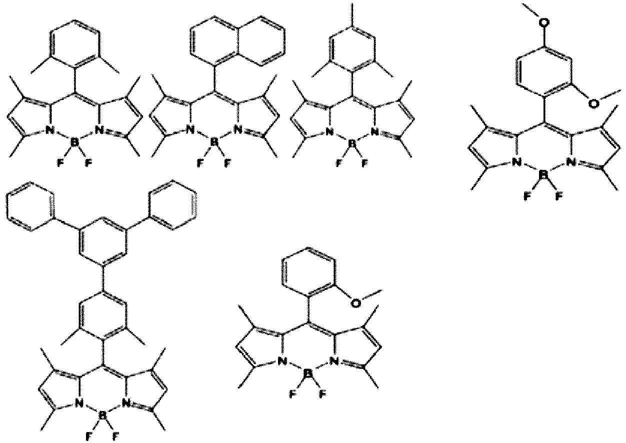

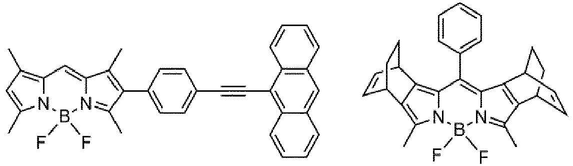

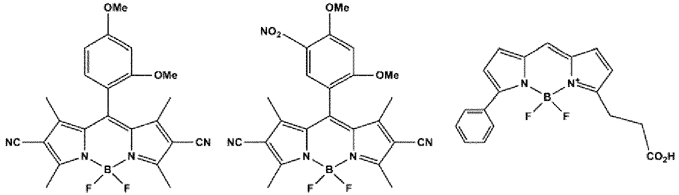

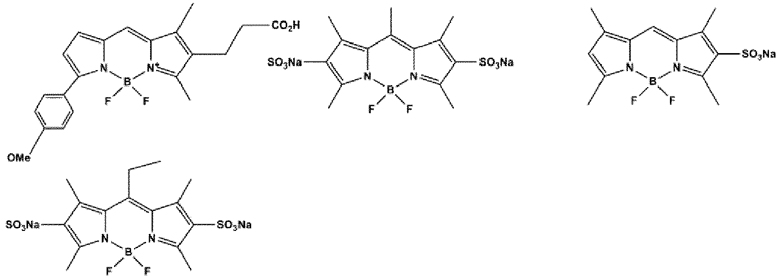

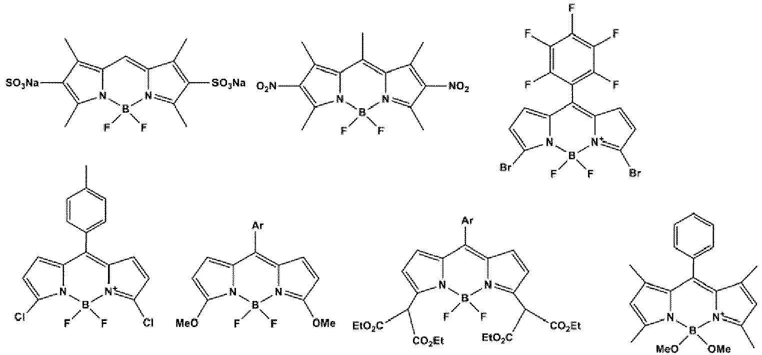

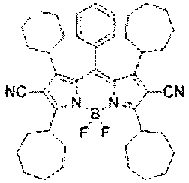

In the structural formulae, Ar is a substituted or unsubstituted aryl group. For example, Ar may be an aryl group substituted with an alkyl group or an alkoxy group.

According to an exemplary embodiment of the present specification, a pyrromethene boron complex-based organic fluorescent substance may be used as the second fluorescent substance.

According to an example, an organic fluorescent substance of the following Formula 2 may be used. 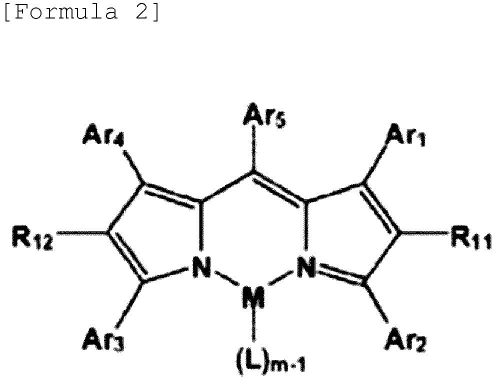
R₁₁, R₁₂, and L are the same as or different from each other, and are each independently hydrogen, an alkyl group, a cycloalkyl group, an aralkyl group, an alkylaryl group, an alkenyl group, a cycloalkenyl group, an alkynyl group, a hydroxyl group, a mercapto group, an alkoxy group, an alkoxyaryl group, an alkylthio group, an arylether group, an arylthioether group, an aryl group, a haloaryl group, a heterocyclic group, halogen, a haloalkyl group, a haloalkenyl group, a haloalkynyl group, a cyano group, an aldehyde group, a carbonyl group, a carboxyl group, an ester group, a carbamoyl group, an amino group, a nitro group, a silyl group, or a siloxanyl group, or are linked to an adjacent substituent to form a substituted or unsubstituted aromatic or aliphatic hydrocarbon or hetero ring,
M is boron, beryllium, magnesium, chromium, iron, nickel, copper, zinc or platinum, and
Ar₁ to Ar₅ are the same as or different from each other, and are each independently hydrogen; an alkyl group; a haloalkyl group; an alkylaryl group; an amine group; an arylalkenyl group unsubstituted or substituted with an alkoxy group; a substituted or unsubstituted heterocyclic group; or an aryl group unsubstituted or substituted with a hydroxy group, an alkyl group or an alkoxy group.

According to an exemplary embodiment, Formula 2 may be represented by the following structural formulae.

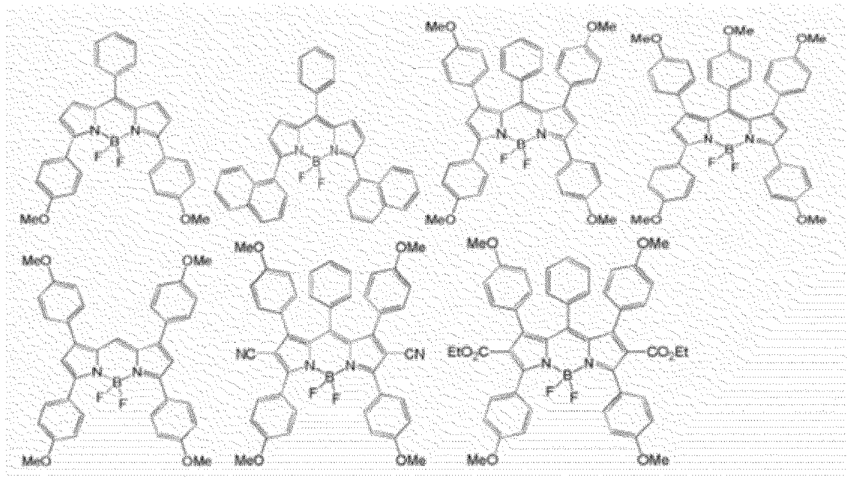

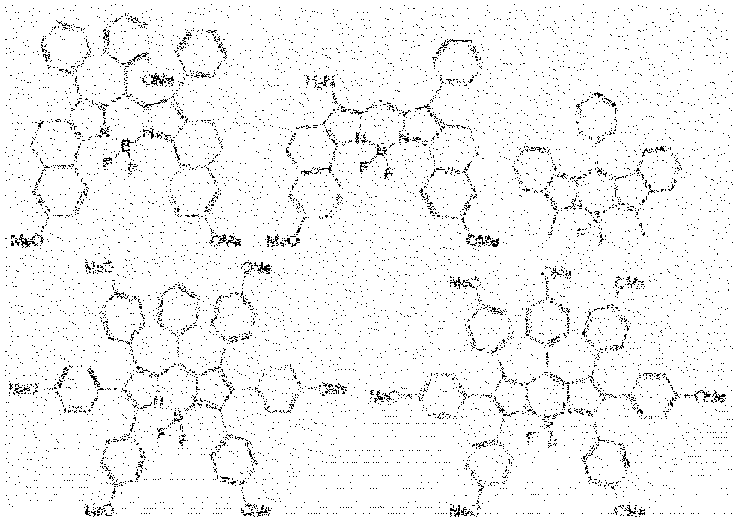

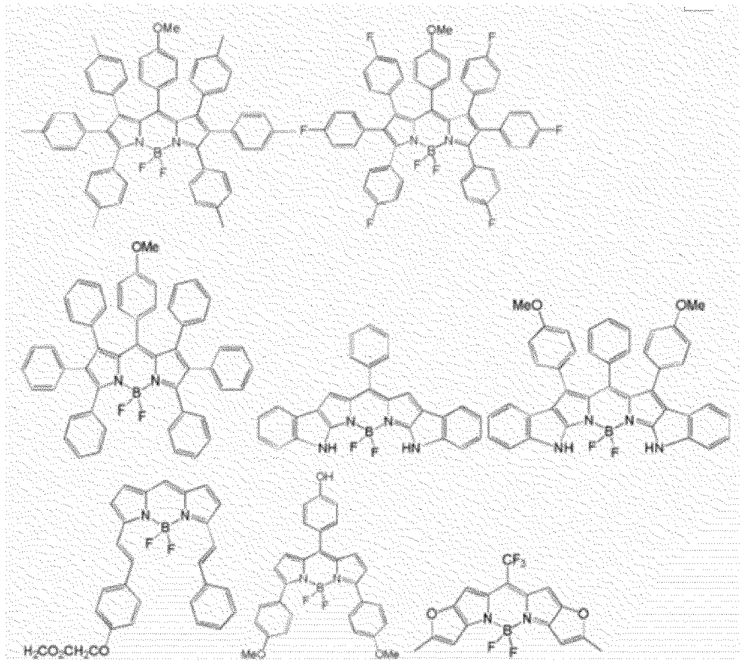

The organic fluorescent substance illustrated above has a light emission peak's full width at half maximum of 40 nm or less in a solution state, and has a light emission peak's full width at half maximum of approximately 50 nm in a film state.

The content of the organic fluorescent substance may be 0.005 wt% to 5 wt% based on 100% of the entire color conversion film.

The color conversion film according to the above-described exemplary embodiment may have a thickness of 2 µm to 200 µm. In particular, the color conversion film may exhibit high brightness even in a small thickness of 2 µm to 20 µm. This is because the content of the fluorescent substance molecules included in a unit volume is higher than that of a quantum dot.

A base material may be provided on one surface of the color conversion film according to the above-described exemplary embodiment. The base material may function as a support at the time of producing the color conversion film. The kind of base material is not particularly limited, and the material or thickness of the base material is not limited as long as the base material is transparent and may function as the support. Here, transparency means that the transmittance of visible light is 70% or more. For example, as the base material, a PET film may be used.

The above-described color conversion film may be produced by coating the above-described resin solution in which the organic fluorescent substance is dissolved on a base material and drying the resin solution, or by extruding the above-described organic fluorescent substance together with the thermoplastic resin to form a film.

Since the above-described organic fluorescent substance is dissolved in the resin solution, the organic fluorescent substance is uniformly distributed in the solution. This is different from a process of producing a quantum dot film, which requires a separate dispersing process.

An additive may be added into the resin solution, if necessary, and for example, a light diffusion particle such as silica, titania, zirconia, and alumina powder may be added.
As for the resin solution in which the organic fluorescent substance is dissolved, the preparation method is not particularly limited as long as the organic fluorescent substance and the thermoplastic resin described above are dissolved in the solution.

According to an example, the resin solution in which the organic fluorescent substance is dissolved may be prepared using a method of preparing a first solution by dissolving an organic fluorescent substance in a solvent, preparing a second solution by dissolving a thermoplastic resin in a solvent, and mixing the first solution and the second solution. When the first solution and the second solution are mixed, it is preferred to uniformly mix the solutions. However, the method is not limited thereto, and it is possible to use a method of simultaneously adding and dissolving an organic fluorescent substance and a thermoplastic resin in a solvent, a method of dissolving an organic fluorescent substance in a solvent and subsequently adding and dissolving a thermoplastic resin, a method of dissolving a thermoplastic resin in a solvent and subsequently adding and dissolving an organic fluorescent substance, and the like.

The organic fluorescent substance included in the solution is the same as described above.

The solvent is not particularly limited, and is not particularly limited as long as the solvent does not adversely affect the coating process and may be removed by subsequent drying. As a non-limiting example of the solvent, it is possible to use toluene, xylene, acetone, chloroform, various alcohol-based solvents, methyl ethyl ketone (MEK), methyl isobutyl ketone (MIBK), ethyl acetate (EA), butyl acetate, cyclohexanone, propylene glycol methylethyl acetate (PGMEA), dioxane, dimethylformamide (DMF), dimethylacetamide (DMAc), dimethylsulfoxide (DMSO), N-methyl-pyrrolidone (NMP), and the like, and one type or a mixture of two or more types may be used.

When the first solution and the second solution are used, the solvents included in each of the solutions may also be the same as or different from each other. Even when different solvents are used in the first solution and the second solution, it is preferred that these solvents have compatibility so as to be mixed with each other.

A process of coating the resin solution, in which the organic fluorescent substance is dissolved, onto a base material may use a roll-to-roll process. For example, the process may be performed by a process of unwinding a base material from a roll on which the base material is wound, coating a resin solution, in which the organic fluorescent substance is dissolved, onto one surface of the base material, drying the resin solution, and then winding the base material again on the roll. When the roll-to-roll process is used, it is preferred that the viscosity of the resin solution is determined within a range in which the process may be performed, and the viscosity may be determined within a range of, for example, 200 cps to 2,000 cps.

As the coating method, various publicly-known methods may be used, and for example, a die coater may also be used, and various bar-coating methods such as a comma coater and a reverse comma coater may also be used.

After the coating, a drying process is performed. The drying process may be performed under conditions required for removing the solvent. For example, a color conversion film including an organic fluorescent substance having desired thickness and concentration may be obtained on a base material by drying the solvent in an oven located close to a coater under a condition to sufficiently evaporate a solvent, in a direction of the base material progressing during the coating process.

According to another exemplary embodiment of the present specification, the light source is not particularly limited, but may be a blue light emission diode emitting blue light. Further, in the exemplary embodiment, the color conversion film may absorb a portion of light incident from a blue light emission diode to switch the light into green or red, or green and red with a high color purity at high efficiency and emit the color(s).

According to still another exemplary embodiment of the present specification, the flexible substrate is not particularly limited, but may be preferably a thin-film glass, a metal thin film, a plastic substrate, or a plastic film.

Still yet another further exemplary embodiment of the present specification provides a lighting module further including a color filter having a cut-on wavelength within a range of 530 nm to 630 nm.

According to an exemplary embodiment of the present specification, the color filter may be produced by using a polymer resin matrix and a light absorbing compound. In this case, as the light absorbing compound, it is possible to freely select an organic pigment, an inorganic pigment, a dye, and the like. A color filter may be formed by applying the resin solution in which the light absorbing compound is dissolved on a substrate to form a coating film, and exposing, developing, and curing the coating film.

The application method is not particularly limited, but a spray method, a roll coating method, a spin coating method, and the like may be used, and in general, the spin coating method is widely used. Further, an application film is formed, and then in some cases, the residual solvent may be partially removed under reduced pressure.

Hereinafter, the present specification will be described in detail with reference to Examples for specifically describing the present specification. However, the Examples according to the present specification may be modified in various forms, and it is not interpreted that the scope of the present application is limited to the Examples described in detail below. The Examples of the present application are provided for more completely explaining the present specification to the person with ordinary skill in the art.

### [Mode for Invention]

### <Example 1>

A first solution was prepared by dissolving a green fluorescent substance of the following structural formula and a red fluorescent substance (TRRD125) manufactured by Toray Industries, Inc., at a molar ratio of 9 : 1 in a solvent dimethylformamide (DMF).

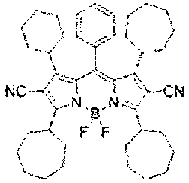

A second solution was prepared by dissolving alpha methyl styrene-styrene-acrylonitrile having a glass transition temperature of 120°C as a thermoplastic resin in the solvent dimethylformamide (DMF).

The first solution and the second solution were mixed, such that the content of the green fluorescent substance and the red fluorescent substance is 3.29 parts by weight and the content of TiO₂ particles is 40 parts by weight based on 100 parts by weight of the thermoplastic resin. A color conversion film was produced by coating the mixed solution on a PET substrate, and then drying the solution.

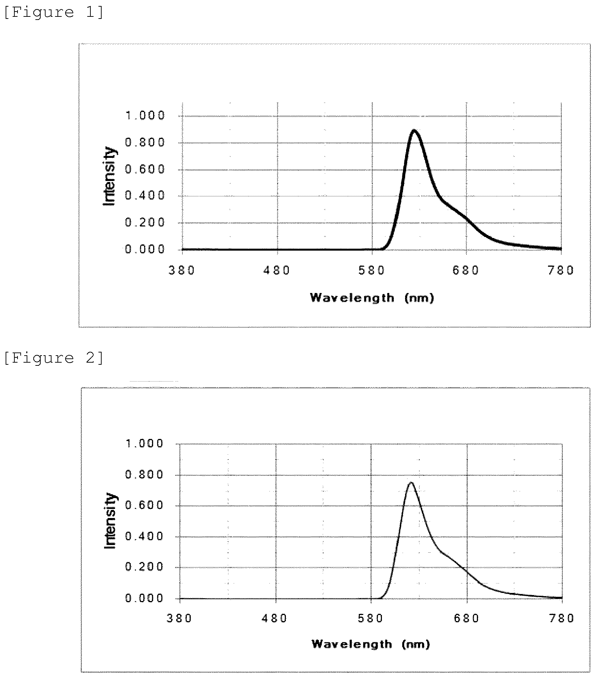

The light emission spectrum of the produced color conversion film was measured by a spectroradiometer (SR series manufactured by Topcon, Inc.). Specifically, the produced color conversion film was stacked on one surface of a light diffusing plate of a case including a blue LED light source module (a maximum light emission wavelength of 450 nm) and the light diffusing plate, a color filter having a cut-on wavelength within a range of 530 nm to 630 nm was stacked on the color conversion film, and then the light emission spectrum of the film was measured, and the results are shown in FIG. 1. According to FIG. 1, for the red light emission of the produced color conversion film, the maximum light emission wavelength was 626 nm, the full width at half maximum was 38 nm, and the color purity was 99.7%, so that a very clear light emission could be implemented.

### <Example 2>

A color conversion film was produced in the same manner as in Example 1, except that a cyclic olefin copolymer (COC) having a glass transition temperature of 138°C was used as the thermoplastic resin. The light emission spectrum of the produced color conversion film was measured by the same method as in Example 1, and the results are shown in FIG. 2. According to FIG. 2, for the red light emission of the produced color conversion film, the maximum light emission wavelength was 620 nm, the full width at half maximum was 36 nm, and the color purity was 99.6%, so that light characteristics equivalent to those in Example 1 were exhibited.

### <Comparative Example 1>

A first solution was prepared by using CaAlSiN₃:Eu²⁺ which is an inorganic fluorescent substance instead of the green fluorescent substance and the red fluorescent substance, and a second solution was prepared by using polystyrene (PS) having a glass transition temperature of 102°C as the thermoplastic resin. The solution was prepared in the same manner as in Example 1, except that 3.3 parts by weight of the inorganic fluorescent substance were used based on the thermoplastic resin.

The light emission spectrum of the produced color conversion film was measured by the same method as in Example 1, and the results are shown in FIG. 3. According to FIG. 3, for the red light emission of the produced color conversion film, the maximum light emission wavelength was 648 nm, the full width at half maximum was 86 nm, and the color purity was 99.4%, so that the color purity and the full width at half maximum were shown to be inferior to those in Example 1. Light characteristics of the color conversion films according to Example 1 and Comparative Example 1 are shown in the following Table 1.

**[Table 1]**

| | Example 1 | Comparative Example 1 |
|---|---|---|
| Maximum light emission wavelength (nm) | 626 | 648 |
| Full width at half maximum (nm) | 38 | 86 |
| Color purity (%) | 99.7% | 99.4% |

### <Comparative Example 2>

A color conversion film was produced in the same manner as in Example 1, except that styrene-acrylonitrile (SAN) having a glass transition temperature of 101°C was used as the thermoplastic resin.

### <Comparative Example 3>

A color conversion film was produced in the same manner as in Example 1, except that the polystyrene (PS) used in Comparative Example 1 was used as the thermoplastic resin.

### <Comparative Example 4>

A color conversion film was produced in the same manner as in Example 1, except that polycarbonate (PC) having a glass transition temperature of 149°C was used as the thermoplastic resin.

After the color conversion films produced in Examples 1 and 2 and Comparative Examples 2 to 4 were stored in an oven at 110°C for 1,000 hours, changes in brightness were observed, and the results are shown in FIG. 4. According to FIG. 4, the color conversion films according to Examples 1 and 2 maintained a level of 90% or more as compared to the initial brightness even after 1,000 hours, whereas the color conversion films according to Comparative Examples 2 to 4 exhibited brightness at a level of 53.8%, 76.5%, and 84.1%, respectively as compared to the initial brightness after 1,000 hours.

As shown in Examples 1 and 2 and Comparative Examples 2 to 4, when a color conversion film is produced by including a thermoplastic resin having a glass transition temperature of 110°C to 145°C, the color conversion film has stability at high temperature and can implement high brightness and excellent color purity.

## Claims

1. A lighting module comprising:
a flexible substrate;
a micro LED light source array provided on the flexible substrate; and
a color conversion film stacked on the micro LED light source array,
wherein the color conversion film comprises a resin matrix and an organic fluorescent substance dispersed in the resin matrix,
wherein the color conversion film has a light emission peak's full width at half maximum of 50 nm or less and has a maximum light emission wavelength within a range of 600 nm to 660 nm, when irradiated with light having a wavelength of 450 nm, and
wherein the resin matrix comprises a thermoplastic resin having a glass transition temperature of 110°C to 145°C, and
the thermoplastic resin comprises one or more of alpha methyl styrene-styrene-acrylonitrile, a cyclic olefin copolymer, phenyl methyl styrene-styrene-acrylonitrile (PMI-SAN), styrene maleic anhydride, cellulose acetate propionate (CAP), poly(4-tert-butylstyrene)(PTBS), poly(methylphenyl)silane (PMPS), poly(4-vinylpyridine), poly(methyl methacrylate)(PMMA), and poly(vinyl methacrylate)(PVMA).

2. The lighting module of claim 1, wherein the color conversion film maintains 90% or more of an initial brightness under a condition of 110°C for 1,000 hours or more.

3. The lighting module of claim 1, wherein the color conversion film further comprises light diffusion particles.

4. The lighting module of claim 1, wherein the color conversion film has a light emission peak's full width at half maximum of 40 nm or less, a maximum light emission wavelength within a range of 620 nm to 660 nm, and a color purity of 99% or more when irradiated with light having a wavelength of 450 nm.

5. The lighting module of claim 1, wherein the light having a wavelength of 450 nm is blue light having a maximum light emission wavelength of 450 nm, a full width at half maximum of 40 nm or less, and a monomodal light emission intensity distribution.

6. The lighting module of claim 1, wherein the organic fluorescent substance comprises a first fluorescent substance having a maximum light emission wavelength within a range of 510 nm to 560 nm irradiated with light having a wavelength of 450 nm, , a second fluorescent substance having a maximum light emission wavelength within a range of 600 nm to 660 nm when irradiated with light having a wavelength of 450 nm, the second fluorescent substance, or a combination thereof.

7. The lighting module of claim 1, wherein the organic fluorescent substance is a pyrromethene boron complex-based organic fluorescent substance.

8. The lighting module of claim 1, wherein the light source is a blue light emission diode emitting blue light.

9. The lighting module of claim 1, wherein the flexible substrate is a thin-film glass, a metal thin film, a plastic substrate, or a plastic film.

10. The lighting module of claim 1, further comprising a color filter having a cut-on wavelength within a range of 530 nm to 630 nm.
